(19)

Europäisches
Patentamt
European
Patent Office
Office européen
des brevets

(11) **EP 1 998 103 A1**

(12) **EUROPEAN PATENT APPLICATION**

(43) Date of publication:
**03.12.2008 Bulletin 2008/49**

(51) Int Cl.:
***F21K 7/00*** *(2006.01)*  ***G02B 6/00*** *(2006.01)*

(21) Application number: **08251857.2**

(22) Date of filing: **28.05.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **01.06.2007 CN 200710074806**

(71) Applicant: **Foxsemicon Integrated Technology,
Inc.
Taiwan 350 (TW)**

(72) Inventor: **Chu, Yuan-Fa,
c/o Foxsemicon Int. Tech. Inc.
Chu-Nan,
Miao-Li Hsien 350 (TW)**

(74) Representative: **Stuttard, Garry Philip
Urquhart-Dykes & Lord LLP
Tower North Central
Merrion Way
Leeds LS2 8PA (GB)**

(54) **Light source assembly and backlight module including the same**

(57)    An exemplary light source assembly includes a light source device, an optical component, and a light pervious filling layer. The light source includes a light pervious cover. The light pervious filling layer is interposed between the light source and the optical component and brought in contact with the light source and the optical component. A refractive index of the light pervious filling layer is between a refractive index of the light pervious cover and a refractive index of the optical component. The light pervious filling layer can reduce a refraction loss and reflection loss of light.

EP 1 998 103 A1

**Description**

**1. Field of the Invention**

The present invention generally relates to a light source assembly and, particularly relates to a light source assembly including a solid state light source

**2. Discussion of related art**

Currently, light emitting diodes (LEDs) are widely employed in various applications such as backlight assembly for liquid crystal displays (LCD). Optical components are required in most LED applications. For example, a light guide plate is employed and serves as the optical component to convert the light emitted from an LED into a surface light.

Generally, the light source is arranged adjacent to the light guide plate and A gap is defined between the light source and the light guide plate. Light emitted from the light source passes through the gap and then enters into the light glide plate. However, a refractive index of the light guide plate is greater than that of air Thus, reflection and refraction occur in the interface between the air gap and the light , guide plate, which compromises the light entering into the light guide plate.

What is needed, therefore, is a light source assembly with reduced reflection and refraction loss and has an improved light transmission rate.

**SUMMARY**

An exemplary light source assembly includes a light source device, an optical component, and a light pervious filling layer. The light source includes a light pervious cover. The light pervious filling layer is interposed between the light source and the optical component and brought in contact with the light source an i the optical component. A refractive index of the light pervious filling layer is between a refractive index of the light pervious cover and a refractive index of the optical component.

This and other features and advantages of the present invention as well as the preferred embodiments thereof and a cleaning apparatus in accordance with the invention will become apparent from the following detailed description and the descriptions of the drawings.

**BRIEF DESCRIPTION OF THE DRAWINGS**

Many aspects of the present invention can be better understood with reference to the following drawings. The components in the drawings are not necessarily drawn to scale, the emphasis instead being placed upon clearly illustrating the principles of the present invention.

FIG. 1 illustrates a light source assembly in accordance with a first embodiment.

FIG. 2 is an exploded view of the light source assemble of FIG. 1.

FIG. 3 illustrates a light path of light emitted from the light source assembly of FIG. 1.

FIG 4 illustrates a light source assembly in accordance with a second embodiment.

FIG 5 illustrates a light source assembly in accordance with a third embodiment.

FIG 7 illustrates a light source assembly in accordance with a fourth. embodiment.

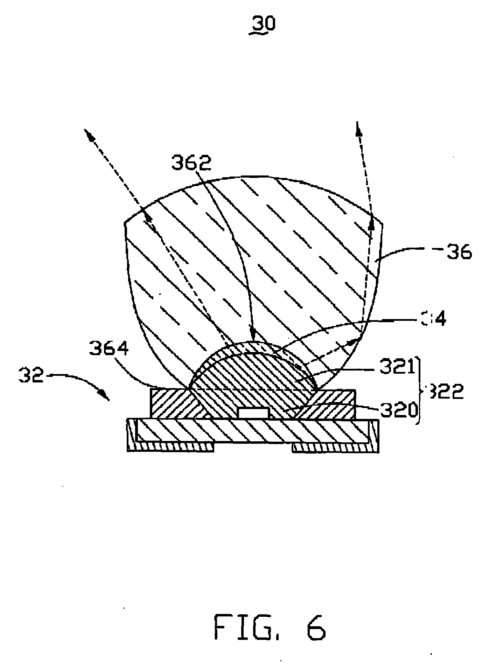

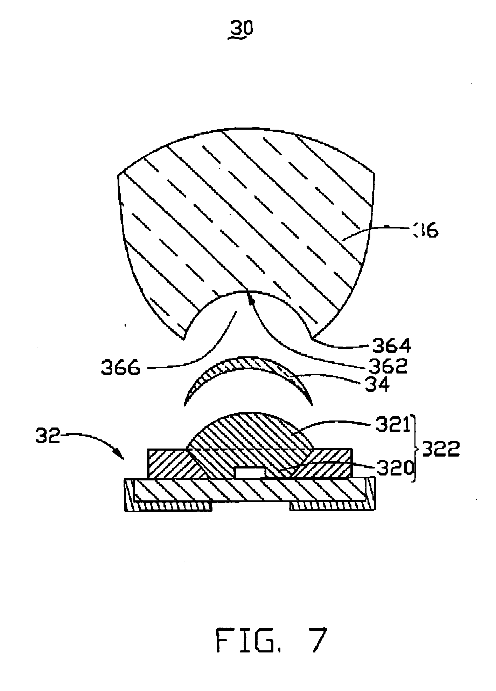

FIG 7 is an exploded schematic view of FIG 6.

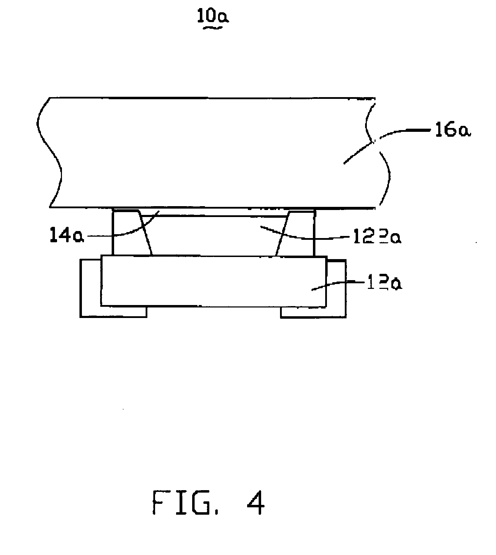

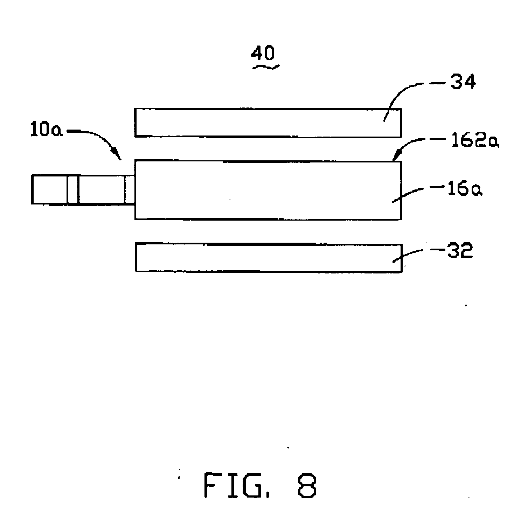

FIG 8 illustrates a back light module including the light source assembly of FIG. 4.

**DETAILED DESCRIPTION OF EXEMPLARY EMBODIMENTS**

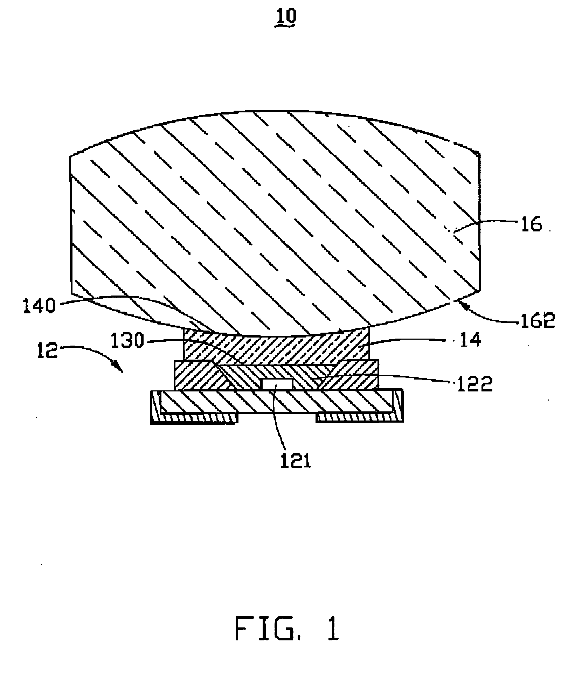

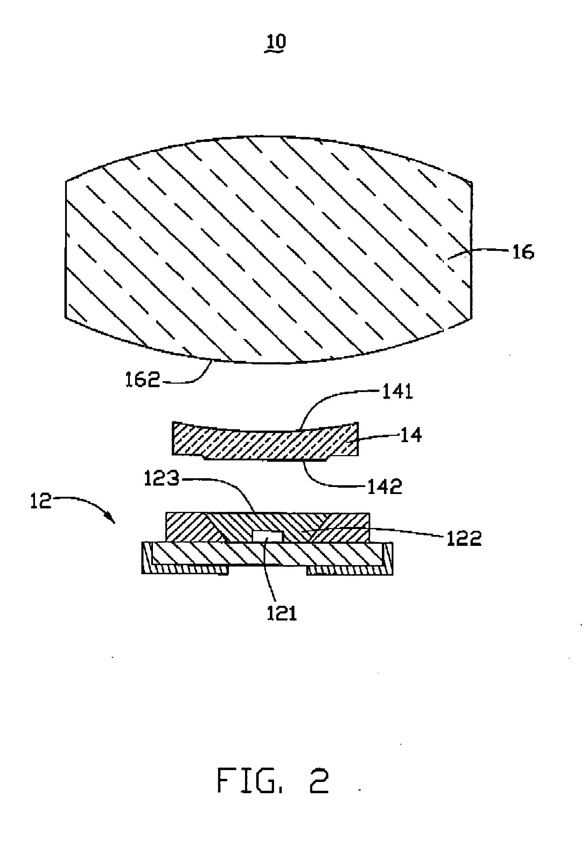

Referring to FIGS. 1 and 2, a light source assembly 10 in accordance with a first embodiment includes a light source device 12, a light pervious filling layer 14, and an optical component 16. The light source device 12 Includes a hight emitting element 121 and a light pervious cover 122 covering the light emitting element 121. The light pervious filling layer 14 is Interposed between and brought in contact with the light pervious cover 122 and the optical component 16.

The light emitting element 121 is a solid state light sou ce such as a light emitting diode (LED) chip, or a laser diode. The light pervious cover 122 encloses the light emitting member 121. The light pervious cover 122 includes a light emission surface 123. The light pervious cover 122 can be made of a light pervious material selected from a group consisting of glass, silicone, and light pervious silicone rubber, light pervious resin such as epoxy resin and polymethyl methacrylate (PMMA).

The optical component 16 is configured for processing converting light conducted by the light pervious filling layer 14 according to a practical demand. For example, the optical component 16 can be a lens, color filter, light pervious plate with opaque pattern formed thereon, and a combination thereof. The lens can be used to diffuse or converge light. The color filter can be used to filter light having a certain wavelength. The light pervious plate can display a certain pattern of light.

The light pervious filling layer 14 includes two opposite surfaces 141, 142. The light pervious filling layer 14 can be made of a light pervious flexible material selected form a group consisting of silicone, light pervious silicon rubber, thermoplastic polyurethane, and polyvinyl chloride. The light pervious filling layer 14 is soft and flexible so that shapes of the two opposite surfaces 141, 142 can be easily transformed so as to perfectly mate with the light emission surface 123 and the light emission surface 162. In particular, when a pressure is applied between the light pervious cover 122 and the optical component 16, the light pervious filling layer 14 is pressed to fully fill interstices between the light pervious cover 122 and the optical component 16. Preferably, the light pervious filling layer 14 includes fluorescent powder distributed therein. The fluorescent powder facilitates light scattering in the ight pervious filling layer 14 thereby improving a uniformity of light extracted from the light pervious filling layer 14.

The light pervious cover 122 and the light pervious fill ng layer 14 define a first interface 130 therebetween. The light pervious filling layer 4 and the optical component 16 define a second interface 140 therebetween. The hight pervious cover 122 has a refractive index of $n_L$, the light pervious filling layer 14 has a refractive index of $n_F$, and the optical component 16 has a refractive index of $n_G$. A light transmission rate of a light beam at the first interface 130 is $T_{LF}$, and a light reflection rate of the light beam at the first interface 130 is $R_{LF}$. A light transmission rate of the light beam at the second interface 140 is $T_{FG}$, and a light reflection rate of the light beam at the second interface 140 is $R_{FG}$.

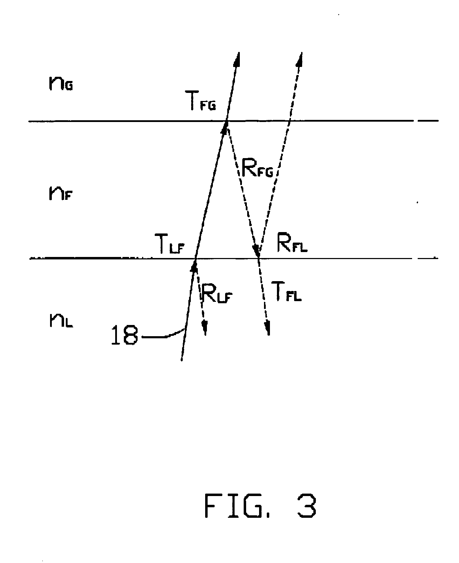

Fig. 3 illustrates a light path of a light beam 18 passing through the light source assembly 10. The light beam 18 is reflected sequentially the first interface 130 and the second interface 140. A total light transmission rate $T$ of he light beam 18 from the light pervious cover 122 to the optical component 16 can be calculated using the following formula:

$$T = T_{LF} T_{FG} \frac{1}{1 - R_{LF} R_{FG}}$$

T is in positive correlation with the relative refractive index at the two boundaries. In other words, the more $n_L/n_F$ and $n_F/n_G$ are close to 1, the more This close to 1. In order to improve the total light transmission rate T, most preferably, the refractive index $n_L$ of the light pervious cover 122, the refractive index $n_F$ of the light pervious filling layer 14, and the refractive index $n_G$ of the optical component 16i are equal to each other, that is, $n_L = n_F = n_G$. In other words, the refractive index of the light pervious filling layer 14 is defined by the formula $n_L = n_F = n_G$. As such, the total light transmission rate T is equal to 1, that is, one hundred percent of the light beam 18 enters the optical component 16. When refractive index $n_L$ of the light pervious cover 122 does not equal the refractive index $n_G$ of the optical component 16 it is advantageously that the refractive index of the light pervious filling layer 14 is defined by a formula $n_L < n_F < n_G$ or $n_L > n_F > n_G$. That is, the refractive index of the light pervious filling layer 14 is between the refractive index of the light pervious cover 122 and the optical component 16. Preferably, the refractive index $n_F$ is defined by a formula

$$n_F = \sqrt{n_L n_G}$$ . Compared to the total light transmission when there is only air between the light pervious cover 122 and the optical component 16, the total light transmission rate T is also greatly improved.

It is to be understood that, during manufacturing of the light source assembly 10, The light pervious filling layer 14 may be preformed on the lig it-emitting portion 122 prior to assembling of the light source assembly 10. In other embodiments, the light pervious filling layer 14 may be preformed on the optical component 16 prior to assembling the light source assembly 10. Still in other embodiments, the light pervious filling layer 14 may be divided into a first portion and a second portion. The first portion is preformed on the light pervious cover 122, and the second portion is preformed on the optical component 16. Upon condition where the material of the light pervious filling layer 14 and the light pervious cover 122 are the same, the light pervious filling layer 14 and the light pervious cover 122 can be integrally formed When the light source device 12 and the optical component 16 are assembled together, the light pervious filling layer 14 is interposed between the light source device 12 and the optical component 16.

As mentioned above, the light pervious filling layer 14 can reduce reflection and refraction loss when the light beam 18 passes through the light pervious filling layer 14 to enter the optical component 16. In addition, a large diverge it angle of light beams and improved light uniformity may be achieved. If the refractive indexes of the light-emitting portion 122, the light pervious filling layer 14 and the optical component 16 are the same or similar, the advantages of the light source assembly 10 are more significant.

Referring to Fig.4, a light source assembly 10a in accordance with a second embodiment is similar to the light source assembly 10 except the optical component of the light source assembly 10a is a light guide plate 16a, a light pervious filling layer 14a is interposed between the light guide plate 16a and the light emitting portion 122a of the light source device 12a.

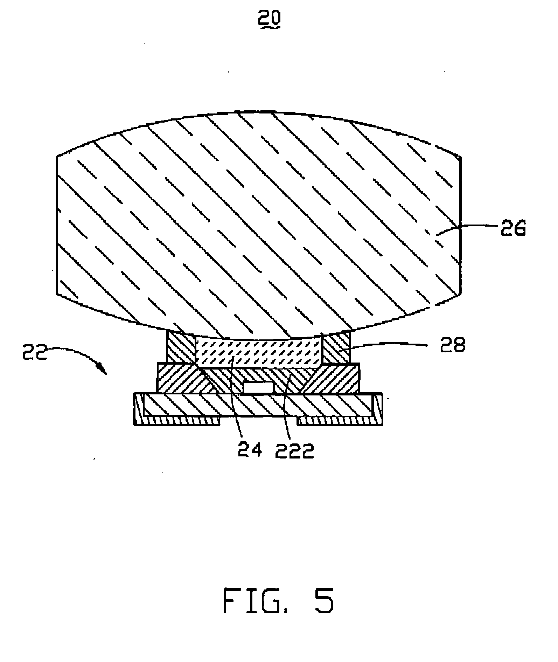

Referring to FIG. 5, a light source assembly 20 in accordance with a third embodiment includes a light source device 22, a light pervious filling layer 24, an optical component 26, and a gasket 28. The light source device 22 includes a light pervious cover 222. The gasket 28 is interposed between the light source device 22 and the optical component 26. The gasket 28, the light source device 22 and the optical component 26 cooperatively defines a sealed receiving space. The receiving space is opposite to the light pervious cover 222. The light pervious filling layer 24 is filled in the receiving space. The light pervious filling layer 24 can be light t pervious liquid with high refractive index such as organic silicone oil, alcohols having a carbon atom number greater than five, and esters having a carbon atom number greater than five. The gasket 28 can be made of a flexible material such as rubber. The optical component 26 can be selected from a group consisting of lens, color filter, light pervious plate with opaque pattern formed thereon and light guide plate. The refractive inde; of the light pervious cover 222, the refractive index of the light pervious filling layer 24 , and the optical component 26 is similar to that of the light source assembly 10. In the third embodiment, the light pervious filling layer 24 is made of liquid material. However, it is understood that the light pervious filling layer 24 can also be flexible solid state material.

Referring to FIGS. 6 and 7, a light source assembly 30 n accordance with a fourth embodiment includes a light source device 32, a light pervious filling layer 34 and an optical component 36. The light source device 32 includes a light pervious cover 322. The light pervious cover 322 includes a base portion 320 and a hemispherical convex structured light pervious cover 321, The light pervious filling layer 34 is interposed between the light source device 32 and the optical component 36.

The optical component 36 includes a concave surface 352 facing the light source device 32. The concave surface 362 has an edge 364. When the optical component 36 is assembled together with the light source device 3: the edge 364 is in tightly contact with the light source device 32. The concave surface 362 thereby defines a sealed receiving space 366 between the light source device 32 and he optical component 36. The receiving space 366 is opposite to the light pervious cover 322. The light pervious filling layer 34 is filled in the sealed receiving space 366.

In the fourth embodiment, the light pervious cover 321 is received in the receiving space 366. The hemispherical convex structured light pervious cover 321 can improve a light scattering angle of the light source device 32 there by increasing distribution uniformity of light beams in the optical component 36. Furthermore, the light pervious cover 321 is received in the optical component 35. I herefore, almost all the light emitted from the light pervious cover 322 can enter the optical component 36. It is understood that the light pervious cover 321 can also be cylinder shaped, prism shaped, cone shaped, cone-frustum shaped, and the light pervious illing layer 34 can be made of a solid state light pervious material or a liquid state light pervious material.

Referring to Fig. 8, a backlight module 40 is provided. The backlight module includes the light source assembly 10a, a light reflection sheet 32, and a Light diffusion sheet 34, The light diffusing sheet 34 is disposed on a light-extracting surface 162a of the light guide plate 16a. The light reflection sheet 32 is disposed on an opposite side of the light guide plate 16a. The light reflection she et 32 is configured for reflecting the light exiting from the light guide plate 16a back into the light guide plate 16a. The light exiting the light guide plate 16a enters the light diffusing sheet 34. The backlight module 40 may be an edge lighting backlight module or bottom lighting backlight module.

Finally, it is to be understood that the above-described embodiments are intended to illustrate rather than limit the invention. Variations may be made to the embodiments without departing from the spirit of the invention as claimed. The above-described embodiments illustrate the scope of the invention out do not restrict the scope of the invention.

**Claims**

1. A light source assembly comprising:

   a light source device comprising a light pervious cover,
   an optical component; and
   a light pervious filling layer comprising two opposite surfaces that are respectively in seamless contact with the light pervious cover and the optical component, wherein a refractive index of the light pervious filling layer is between a refractive index of the light pervious cover and a refractive index of the optical component.

2. The light source assembly as claimed in claim 1, wherein a refractive index of the light pervious filling layer is defined by the following formula $n_L \leq n_F \leq n_G$, wherein $n_L$ represents the refractive index of the light pervious cover, $n_F$ represents the refractive index of the light pervious filling layer, and $n_G$ represents the refractive index of the optical component.

3. The light source assembly as claimed in claim 2, wherein the refractive index of the light pervious filling layer is defined by the following formula

   $$n_F = \sqrt{n_L n_G} \ .$$

4. The light source assembly as claimed in any preceding claim, wherein the optical component is selected from the group consisting of a lens, a color filter and a transparent plate with opaque pattern formed thereon.

5. The light source assembly as claimed in any preceding claim, wherein the light pervious filling layer comprises fluorescent powders distributed therein.

6. The light source assembly as claimed in any preceding claim, wherein the light pervious filling layer is flexible.

7. The light source assembly as claimed in claim 6, wherein the light pervious filling layer is comprised of a material selected from the group consisting of silicone, silicone rubber, thermoplastic polyurethane and polyvinyl chloride.

8. A light source assembly comprising:

   a light source comprising a light pervious cover;
   an optical component, wherein the light source and the optical component define a sealed receiving space therebetween, wherein the receiving space is opposite to the light pervious cover; and

a light pervious filling layer filled within the receiving space, wherein a refractive index of the light pervious filling layer is between a refractive index of the light pervious cover and a refractive index of the optical component.

9. The light source assembly as claimed in claim 8, wherein a refractive index of the light pervious filling layer is defined by the fallowing formula $n_L \leq n_F \leq n_G$, wherein $n_L$ represents the refractive index of the light pervious cover, $M_F$ represents the refractive index of the light pervious filling layer, and $n_G$ represents the refractive index of the optical component

10. The light source assembly as claimed in claim 9, wherein ther refractive index of the light pervious filling layer is defined by the following formula

$$n_I = \sqrt{n_L n_G}.$$

11. The light source assembly as claimed in any of claims 8 to 10, wherein the optical component is selected from a group consisting of a lens, a color filler, a light pervious plate with opaque pattern formed thereon and a light guide plate.

12. The light source assembly as claimed in any of claims 8 to 11, wherein the light pervious filling layer comprises fluorescent powders or diffusers distributed therein.

13. The light source assembly as claimed in any of claims 8 to 12, wherein the light pervious filling layer is made of a flexible material.

14. The light source assembly as claimed in claim 13, wherein the flexible material is selected from the group consisting of silicone, light pervious silico ie rubber, thermoplastic polyurethane and polyvinyl chloride.

15. The light source assembly as claimed in claim 8, wherein the light pervious filling layer is made of a liquid material.

16. The light source assembly as claimed in claim 15, wherein the liquid material is selected from a group consisting of organic silicone oil, alcohols having a carbon atom number of greater than five and esters having a carbon atom number of greater than five.

17. The light source assembly as claimed in any of claims 8 to 16 further comprising a gasket disposed between the light source and the optical component, wherein the gasket, the light pervious cover and the optical component cooperatively define the sealed receiving space.

18. The light source assembly as claimed in claim 8, wherein the optical component comprises a concave surface facing the light pervious cover.

19. A backlight module comprising:

a light source device comprising a light emitting chip and a light pervious cover covering the light emitting chip,
a light guide plate, and
a light pervious layer interposed between and brought into contact with the light pervious cover and the light guide plate, wherein a refractive index of the light pervious filling layer is between a refractive index of the light pervious cover and the optical component.

20. The backlight module as claimed in claim 19, further comprising a light reflection sheet and a light diffusion sheet respectively arranged at opposite: ides of the light guide plate.

21. The backlight module as claimed in claim 19 or 20, wherein the refractive index of the light pervious layer is approximately equal to the square root oof the product of the refractive index of the optical light guide plate and the refractive index of the light pervious cover.

10

FIG. 1

<u>10</u>

FIG. 2

$n_G$

$T_{FG}$

$n_F$

$R_{FG}$

$T_{LF}$ $R_{FL}$

$n_L$ 18 $R_{LF}$ $T_{FL}$

FIG. 3

10a

16a

14a

122a

12a

FIG. 4

20

FIG. 5

<u>30</u>

FIG. 6

<u>30</u>

FIG. 7

FIG. 8

**European Patent Office**

## EUROPEAN SEARCH REPORT

Application Number

EP 08 25 1857

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/081360 A1 (BAILEY EDWARD [US] ET AL) 12 April 2007 (2007-04-12) | 1,2,4, 6-9,11, 13-19 | INV. F21K7/00 G02B6/00 |
| Y | * abstract * * paragraphs [0011], [0031] - [0037], [0077] * * figures 7,7g * | 5,12 | |
| Y | US 2004/100789 A1 (JU CHUANG MENG [TW]) 27 May 2004 (2004-05-27) | 5,12 | |
| A | * abstract * * paragraphs [0002], [0006], [0028] * | 20 | |
| X | US 2005/254258 A1 (LEE JONG-SEO [KR]) 17 November 2005 (2005-11-17) * paragraphs [0052], [0059] - [0066]; figures 1,3 * | 1,2,4,8, 9,11, 19-21 | |
| X | US 2004/080926 A1 (CHEN WEI CHOU [TW] ET AL) 29 April 2004 (2004-04-29) | 1-3,8-10 | TECHNICAL FIELDS SEARCHED (IPC) |
| A | * paragraph [0041] * | 21 | F21K G02B |
| A | US 2002/057057 A1 (SORG JORG-ERICH [DE] SORG JOERG-ERICH [DE]) 16 May 2002 (2002-05-16) * abstract; figure 2 * * paragraph [0047] * | 4,11,18 | |
| A | CN 1 834 133 A (TIANCI ORGANIC SILICON TECH CO [CN]) 20 September 2006 (2006-09-20) * abstract * | 16 | |

The present search report has been drawn up for all claims

| Place of search | Date of completion of the search | Examiner |
|---|---|---|
| The Hague | 26 August 2008 | Cohen, Adam |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 25 1857

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2008

| Patent document cited in search report | | Publication date | Patent family member(s) | | Publication date |
|---|---|---|---|---|---|
| US 2007081360 | A1 | 12-04-2007 | US 2008062701 | A1 | 13-03-2008 |
| US 2004100789 | A1 | 27-05-2004 | NONE | | |
| US 2005254258 | A1 | 17-11-2005 | KR 20050107033 | A | 11-11-2005 |
| US 2004080926 | A1 | 29-04-2004 | US 2006262515 | A1 | 23-11-2006 |
| US 2002057057 | A1 | 16-05-2002 | CN 1348608 | A | 08-05-2002 |
| | | | CN 1645638 | A | 27-07-2005 |
| | | | CN 1881635 | A | 20-12-2006 |
| | | | CN 1881636 | A | 20-12-2006 |
| | | | WO 0065664 | A1 | 02-11-2000 |
| | | | DE 19918370 | A1 | 02-11-2000 |
| | | | JP 2002543594 | T | 17-12-2002 |
| | | | TW 575966 | B | 11-02-2004 |
| CN 1834133 | A | 20-09-2006 | NONE | | |

EPO FORM P0459

For more details about this annex : see Official Journal of the European Patent Office, No. 12/82